# EUROPEAN PATENT SPECIFICATION

(11) **EP 1 912 250 B1**
(45) Date of publication and mention of the grant of the patent: **29.09.2010**
(21) Application number: 07017144.2
(22) Date of filing: 31.08.2007
(51) Int. Cl.: H01L 21/00, B26D 7/00

(54) **Adhesive tape cutting method and tape cutting apparatus**
Schneideverfahren für ein Klebeband und Vorrichtung zum Schneiden eines Klebebands
Procédé de découpe de bande adhésive et appareil de découpage d'une bande adhésive

(30) Priority: 07.09.2006 JP 2006243003
(43) Date of publication of application: 16.04.2008
(73) Proprietor: NITTO DENKO CORPORATION, Ibaraki-shi, Osaka 567-8680 (JP)
(72) Inventor: Yamamoto, Masayuki, Ibaraki-shi Osaka 567-8680 (JP)
(74) Representative: Schildberg, Peter

(56) References cited:
- EP-A- 1 320 121
- EP-A- 1 339 095
- JP-A- 10 116 884
- US-A1- 2006 068 524

## Description

### BACKGROUND OF THE INVENTION

### (1) Field of the Invention

The present invention relates to an adhesive tape cutting method for joining a supporting adhesive tape to a ring frame and a semiconductor wafer such that the ring frame holds the semiconductor wafer, and then cutting the adhesive tape in such a manner that a cutter blade travels along a contour of the ring frame, and an adhesive tape joining apparatus using the same. In particular, the present invention relates to a technique for cutting and joining an adhesive tape along and to a ring frame with good accuracy.

### (2) Description of the Related Art

A semiconductor wafer (hereinafter, simply referred to as a "wafer") having a front face on which a pattern is formed is made thinner in thickness by back grinding. The wafer subjected to the back grinding is transported to a mount apparatus. In the mount apparatus, the wafer is joined to and held by a ring frame through a supporting adhesive tape. Herein, a disc-shaped cutter blade capable of rotating freely is pressed against the strip-shaped adhesive tape joined to the ring frame and the wafer positioned at a center of the ring frame; thus, the adhesive tape is cut along a contour of the ring frame (refer to JP-A 62-174940).

It is considered herein that the adhesive tape is cut in the conventional manner. In the case where the adhesive tape is cut by the cutter blade, first, a cutting edge of the cutter blade penetrates through the adhesive tape. Thereafter, the cutter blade travels in a state that the cutting edge thereof is pressed against a tape joined side of the ring frame. Consequently, a notched groove is formed on the tape joined side of the ring frame due to the contact with the cutter blade.

The ring frame for holding the wafer is collected for reuse after being subjected to processing such as dicing. In a case that such a ring frame is reused, if an adhesive tape joined to the ring frame is cut by the cutter blade, the sharp cutting edge of the cutter blade is fitted into the notched groove formed on the surface of the ring frame, so that the cutter blade travels on a pathway which is different from a preset traveling pathway. This causes a problem of a cutting failure that the adhesive tape cannot be cut along the contour of the ring frame because a cutting start position does not correspond with a cutting end position.

In addition, when the cutter blade is fitted into the notched groove, the cutting edge thereof is susceptible to wear. Consequently, a service life of the cutter blade becomes short, and the cutter blade must be exchanged frequently. That is, there is a problem of deterioration in workability.

From document EP 1 320 121 A2 a semiconductor wafer transport method and apparatus have become known. For cutting a supporting adhesive tape through which a ring frame holds a semiconductor wafer, a cutting mechanism with a conventionally shaped cutter blade is used. A similar method and apparatus is known from document US 2006/0068524 A1.

From document EP 1 339 095 A2 a method of cutting a protective tape and a protective tape applying apparatus have become known. These also use a cutting mechanism for cutting a supporting adhesive tape through which a ring frame holds a semiconductor wafer. The cutting mechanism uses a conventionally shaped cutter blade having a sharp cutting edge.

### SUMMARY OF THE INVENTION

An object of the present invention is to provide an adhesive tape cutting method according to claim 1 capable of cutting a supporting adhesive tape, which allows a ring frame to hold a semiconductor wafer, with good accuracy while improving the workability, and an adhesive tape joining apparatus according to claim 5 using the same.

In order to accomplish the aforementioned object, the present invention adopts the following configuration:

A method for cutting a supporting adhesive tape through which a ring frame holds a semiconductor wafer, the method comprising the step of: cutting a supporting adhesive tape along a contour of a ring frame in such a manner that the supporting adhesive tape is stuck with a cutter blade having a flat plane obtained by forming a sharp cutting edge into a wedge shape.

With this method according to the present invention, even when the cutting edge of the cutter blade penetrates through the adhesive tape upon cutting of the adhesive tape, a contact area of the cutting edge of the cutter blade with respect to the ring frame is enlarged. Therefore, the cutting edge is not fitted into a notched groove formed on the ring frame. Accordingly, the cutter blade travels on a preset traveling pathway, so that a cutting start position corresponds with a cutting end position. As a result, there occurs no cutting failure.

Moreover, the cutting edge of the cutter blade is not fitted into the notched groove, and therefore does not receive unnecessary frictional resistance. As a result, the service life of the cutter blade can be prolonged. Thus, a frequency of exchange of the cutter blade can be reduced, so that workability can be improved.

Further, even when the cutter blade cuts the adhesive tape in such a state that the cutting edge thereof comes into contact with the ring frame, the flat plane formed at the cutting edge of the cutter blade prevents formation of a notched groove on the ring frame. Accordingly, the ring frame can be used repeatedly.

In the present invention, the adhesive tape may be cut in a state that the flat plane formed at the cutting edge of the cutter blade with which the adhesive tape is stuck is close to the tape joined side of the ring frame while the flat plane is left on an adhesive layer of the adhesive tape.

In this case, preferably, the adhesive tape is cut while a gap from the tape joined side of the ring frame to the flat plane of the cutter blade is adjusted so as to be constant.

With the method according to the present invention, the cutting edge of the cutter blade does not come into contact with the ring frame. Therefore, the cutting edge of the cutter blade can be prevented from being worn.

In order to accomplish the aforementioned object, the present invention also adopts the following configuration:

An apparatus for joining a semiconductor wafer to a ring frame through a supporting adhesive tape such that the ring frame holds the semiconductor wafer, the apparatus comprising: wafer holding means for holding a semiconductor wafer; frame holding means for holding a ring frame so as to be opposite to the semiconductor wafer held by the wafer holding means; tape supply means for supplying a strip-shaped supporting adhesive tape toward the ring frame; joining means allowing a joining member to move while being pressed against a non-adhesive surface of the adhesive tape, for joining the semiconductor wafer to the ring frame such that the ring frame holds the semiconductor wafer; a cutting mechanism provided with a cutter blade having a flat plane obtained by forming a sharp cutting edge into a wedge shape, for cutting the adhesive tape along a contour of the ring frame in such a manner that the adhesive tape is stuck with the cutter blade; and removal means for removing the unnecessary portion of the cut adhesive tape from the ring frame.

With the apparatus according to the present invention, the cutter blade having the flat plane obtained by forming the cutting edge into the wedge shape cuts the supporting adhesive tape joined to the ring frame and the semiconductor wafer. Herein, the cutting edge penetrating through the adhesive tape is moved as follows.

For example, the cutter blade cuts the adhesive tape along the contour of the ring frame while the flat plane thereof comes into contact with the tape joined side of the ring frame. Moreover, the cutter blade cuts the adhesive tape in a state that the cutter blade is close to the tape joined side of the ring frame while the cutting edge thereof is left on an adhesive layer of the adhesive tape.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
Fig. 1 is a perspective view illustrating a general configuration of a semiconductor wafer mount apparatus according to an embodiment of the present invention;
Fig. 2 is a front view illustrating a tape cutting mechanism;
Fig. 3 is a perspective view illustrating main components of the tape cutting mechanism;
Fig. 4 is a plan view illustrating the main components of the tape cutting mechanism;
Fig. 5 is an enlarged perspective view illustrating a cutting edge of a cutter blade;
Fig. 6 is a sectional view illustrating a state that a supporting adhesive tape is stuck with the cutter blade; and
Figs. 7 to 10 illustrate supporting adhesive tape cutting operations performed by the apparatus according to the embodiment.

### DESCRIPTION OF THE PREFERRED EMBODIMENT

Hereinafter, description will be given of one embodiment of the present invention with reference to the drawings.

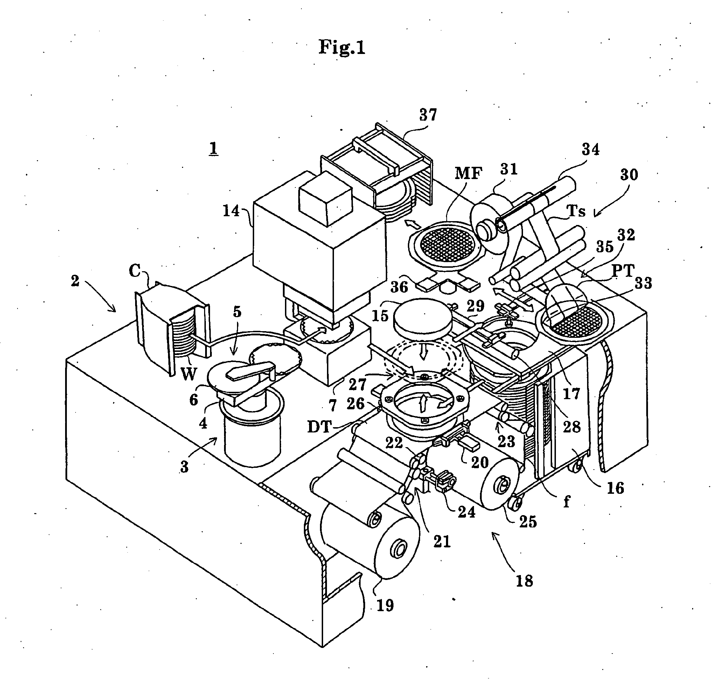

Fig. 1 is a cutaway perspective view illustrating a general configuration of a semiconductor wafer mount apparatus according to one embodiment of the present invention.

The semiconductor wafer mount apparatus 1 according to this embodiment includes a wafer supply section 2, a wafer transport mechanism 3, an alignment stage 7, an ultraviolet-ray irradiation unit 14, a chuck table 15, a ring frame supply section 16, a ring frame transport mechanism 17, a tape processing section 18, a ring frame lift mechanism 26, a mount frame preparation section 27, a first mount frame transport mechanism 29, a separation mechanism 30, a second mount frame transport mechanism 35, a turn table 36 and a mount frame collection section 37. Herein, the wafer supply section 2 includes a cassette C housing wafers W, each subjected to a back grinding process, in a stacked manner. The wafer transport mechanism 3 includes a robot arm 4 and a pressing mechanism 5. The alignment stage 7 performs alignment on a wafer W. The ultraviolet-ray irradiation unit 14 irradiates, with ultraviolet rays, a wafer W placed on the alignment stage 7. The chuck table 15 suction holds a wafer W. The ring frame supply section 16 houses ring frames f in a stacked manner. The ring frame transport mechanism 17 transfers a ring frame f to a supporting adhesive tape DT which is a dicing tape. The tape processing section 18 joins the adhesive tape DT to a bottom side of a ring frame f. The ring frame lift mechanism 26 allows a ring frame f, to which the adhesive tape DT is joined, to move vertically. The mount frame preparation section 27 joins and integrates a wafer W to and into a ring frame f, to which the adhesive tape DT is joined, thereby preparing a mount frame MF. The first mount frame transport mechanism 29 transports a mount frame MF after preparation of the mount frame MF. The separation mechanism 30 separates a protective tape PT joined to a front face of a wafer W. The second mount frame transport mechanism 35 transports a mount frame MF in which a protective tape PT is separated from a wafer W by the separation mechanism 30. The turn table 36 changes a direction of a mount frame MF, and transports the mount frame MF. The mount frame collection section 37 houses mount frames MF in a stacked manner.

The wafer supply section 2 is provided with a cassette bench (not illustrated). The cassette C is placed on the cassette bench and houses wafers W, each having a patterned face (hereinafter, appropriately referred to as a "front face") to which a protective tape PT is joined, in a stacked manner. Herein, each wafer W is in a horizontal position while a patterned face thereof is directed upward.

The wafer transport mechanism 3 is turned and vertically moved by a drive mechanism (not illustrated). More specifically, the wafer transport mechanism 3 adjusts a position of a wafer holding part (to be described later) of the robot arm 4 and a position of a pressing plate 6 (to be described later) of the pressing mechanism 5, and transports a wafer W from the cassette C to the alignment stage 7.

In the wafer transport mechanism 3, the wafer holding part (not illustrated) is provided at a tip end of the robot arm (hereinafter, simply referred to as the "arm") 4 and is formed into a horse-shoe shape. The wafer holding part of the arm 4 can be inserted between wafers W housed in the cassette C in a stacked manner. Herein, the wafer holding part provided at the tip end of the arm 4 includes a suction hole for holding a back face of a wafer W by vacuum suction.

In the wafer transport mechanism 3, the pressing plate 6 is provided at a tip end of the pressing mechanism 5 and is formed into a circular shape which is almost identical to a shape of a wafer W. The pressing plate 6 has an arm portion which can advance/retreat so as to move above a wafer W placed on the alignment stage 7. Herein, the shape of the pressing plate 6 is not limited to the circular shape as long as the pressing plate 6 can correct warpage occurring at a wafer W. For example, a tip end of a rod-like member may be pressed against a warped wafer W.

The pressing mechanism 5 is actuated if a suction failure occurs at a time when a wafer W is placed on a holding table (to be described later) of the alignment stage 7. Specifically, if the holding table cannot suction hold a warped wafer W, the pressing plate 6 presses a front face of the wafer W, thereby correcting the warpage, that is, flattening the wafer W. In this state, the holding table vacuum sucks a back face of the wafer W.

The holding table of the alignment stage 7 performs alignment on a wafer W placed thereon on the basis of an orientation flat or a notch formed at an outer periphery of the wafer W, and entirely vacuum sucks a back face of the wafer W.

Moreover, the holding table of the alignment stage 7 suction holds a wafer W in a state that warpage occurring at the wafer W is corrected by the pressing plate 6.

Further, the alignment stage 7 is movable. That is, the alignment stage 7 moves from an initial position to an intermediate position while suction holding a wafer W. At the initial position, herein, the alignment stage 7 performs alignment on the wafer W placed thereon. Further, the intermediate position is located between the chuck table 15 and the ring frame lift mechanism 26 each disposed above the tape processing section 18 in a vertical direction (to be described above).

The ultraviolet-ray irradiation unit 14 is disposed above the alignment stage 7 situated at the initial position. The ultraviolet-ray irradiation unit 14 irradiates, with ultraviolet rays, a protective tape PT which is a ultraviolet-ray curable type adhesive tape and is joined to a front face of a wafer W. In other words, the ultraviolet-ray irradiation unit 14 intends to lower adhesion of a protective tape PT by irradiation with the ultraviolet rays.

The chuck table 15 is formed into a circular shape which is almost identical to a shape of a wafer W so as to entirely vacuum suck a front face of the wafer W, and is vertically moved from a standby position located above the tape processing section 18 to a position where the wafer W is joined to a ring frame f, by a drive mechanism (not illustrated).

In other words, the chuck table 15 comes into contact with a wafer W held by the holding table while being flattened, and then suction holds the wafer W.

Moreover, the chuck table 15 is inserted in an opening of the ring frame lift mechanism 26 for suction holding a ring frame f having a bottom side to which an adhesive tape DT is joined (to be described later). Then, the chuck table 15 moves downward to a position where a wafer W is close to the adhesive tape DT at a center of the ring frame f.

Herein, the chuck table 15 and the ring frame lift mechanism 26 are held by a holding mechanism (not illustrated). It is to be noted that the chuck table 15 corresponds to wafer holding means according to the present invention and the ring frame lift mechanism 26 corresponds to frame holding means according to the present invention.

The ring frame supply section 16 is of a wagon type, and has a bottom side on which wheels are provided. Moreover, the ring frame supply section 16 is housed in a main body of the semiconductor wafer mount apparatus 1. Further, the ring frame supply section 16 has the following configuration that ring frames f housed therein in a stacked manner sequentially slide upward and are taken out of an upper opening thereof.

The ring frame transport mechanism 17 vacuum sucks uppermost one of ring frames f housed in the ring frame supply section 16 one by one, and then transports the ring frame f to an alignment stage (not illustrated) and a position where the adhesive tape DT is joined to the ring frame f in succession. The ring frame transport mechanism 17 also serves as a holding mechanism for holding the ring frame f at the position where the adhesive tape DT is joined to the ring frame f.

The tape processing section 18 includes a tape supply section 19, a tensioning mechanism 20, a joining unit 21, a tape cutting mechanism 24, a removal unit 23 and a tape collection section 25. Herein, the tape supply section 19 supplies the adhesive tape DT. The tensioning mechanism 20 applies a tension to the adhesive tape DT. The joining unit 21 joins the adhesive tape DT to a ring frame f. The tape cutting mechanism 24 cuts the adhesive tape DT joined to the ring frame f. The removal unit 23 removes the unnecessary portion of the adhesive tape DT cut by the tape cutting mechanism 24 from the ring frame f. The tape collection section 25 collects the cut unnecessary tape. It is to be noted that the tape supply section 19 corresponds to tape supply means according to the present invention, the joining unit 21 corresponds to joining means according to the present invention, the tape cutting mechanism 24 corresponds to a cutting mechanism according to the present invention, and the removal unit 23 corresponds to removal means according to the present invention.

The tensioning mechanism 20 grasps both ends of the adhesive tape DT in a width direction to apply a tension to the adhesive tape DT in the tape width direction. If the adhesive tape DT to be used herein is soft, a tension applied thereto in a tape supplying direction causes vertical wrinkles on a surface thereof in the tape supplying direction. In order to avoid generation of such vertical wrinkles and to uniformly join the adhesive tape DT to a ring frame f, the tensioning mechanism 20 applies the tension to the adhesive tape DT in the tape width direction.

The joining unit 21 is disposed at a standby position located obliquely downward of a ring frame f held above the adhesive tape DT (an obliquely lower left portion in Fig. 1). The joining unit 21 includes a joining roller 22. When the ring frame transport mechanism 17 transports the ring frame f to an adhesive tape joining position and, then, the tape supply section 19 starts to supply the adhesive tape DT toward the ring frame f, concurrently, the joining roller 22 moves to a joining operation start position located at a right end in the tape supplying direction.

After arrival at the joining operation start position, the joining roller 22 moves upward to press the adhesive tape DT against the ring frame f. Then, the joining roller 22 rolls on the adhesive tape DT from the joining operation start position toward a standby position; thus, the adhesive tape DT is joined to the ring frame f. It is to be noted that the joining roller 22 corresponds to a joining member according to the present invention.

The removal unit 23 removes the unnecessary portion of the adhesive tape DT cut by the tape cutting mechanism 24 (to be described later) from the ring frame f. More specifically, after completion of the joining of the adhesive tape DT to the ring frame f and the cutting of the adhesive tape DT, the tensioning mechanism 20 releases the grasp of the adhesive tape DT. Then, the removal unit 23 moves toward the tape supply section 19 over the ring frame f, and removes the unnecessary portion of the cut supporting adhesive tape DT from the ring frame f.

The tape cutting mechanism 24 is disposed below the adhesive tape DT when a ring frame f is placed thereon. When the joining unit 21 joins the adhesive tape DT to the ring frame f, the tensioning mechanism 20 releases the grasp of the adhesive tape DT. Thereafter, the tape cutting mechanism 24 moves upward, and then cuts the adhesive tape DT along a contour of the ring frame f. Hereinafter, description will be given of a specific configuration of the tape cutting mechanism 24.

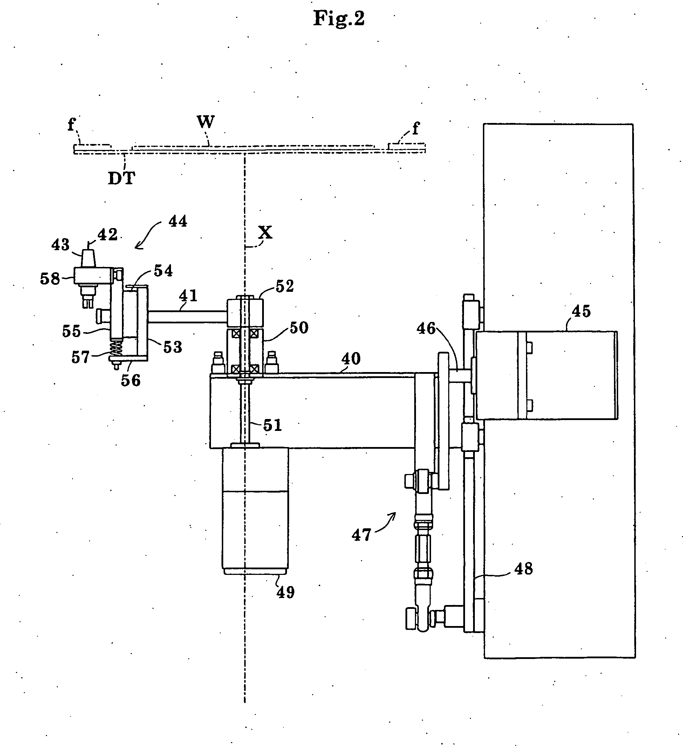

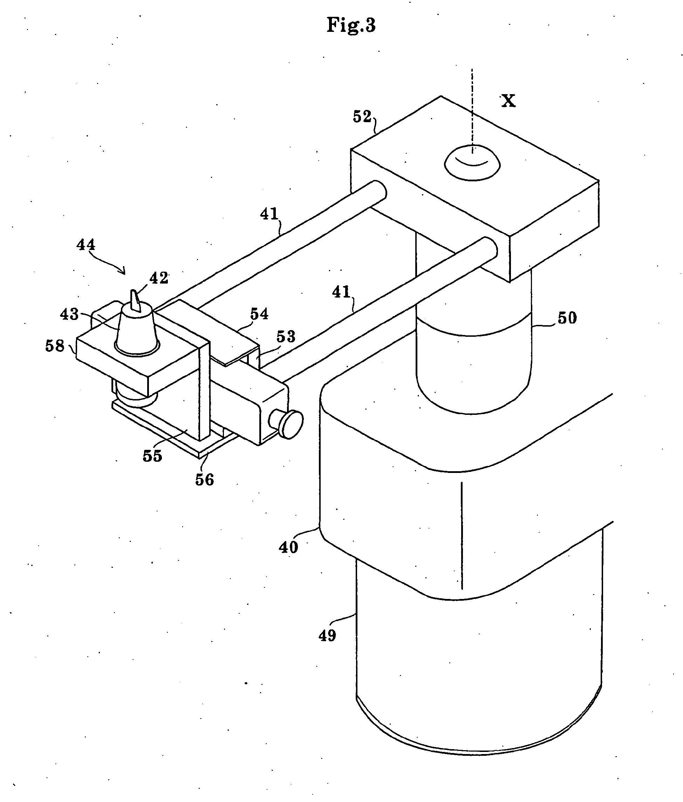

As illustrated in Figs. 2 and 3, the tape cutting mechanism 24 has the following configuration that a pair of support arms 41 are provided in parallel on a movable bench 40 which is driven to move vertically. Herein, the pair of support arms 41 are situated above a center of a ring frame f and are driven to rotate about a vertical axis center X. In addition, a cutter unit 44 is provided at a free end side of the support arm 41. The cutter unit 44 includes a cutter holder 43 to which a cutter blade 42 is attached in a state that a cutting edge thereof is directed upward. When the support arms 41 are turned about the vertical axis center X, the cutter blade 42 travels along a contour of a ring frame f to which the adhesive tape DT is joined, thereby cutting the adhesive tape DT.

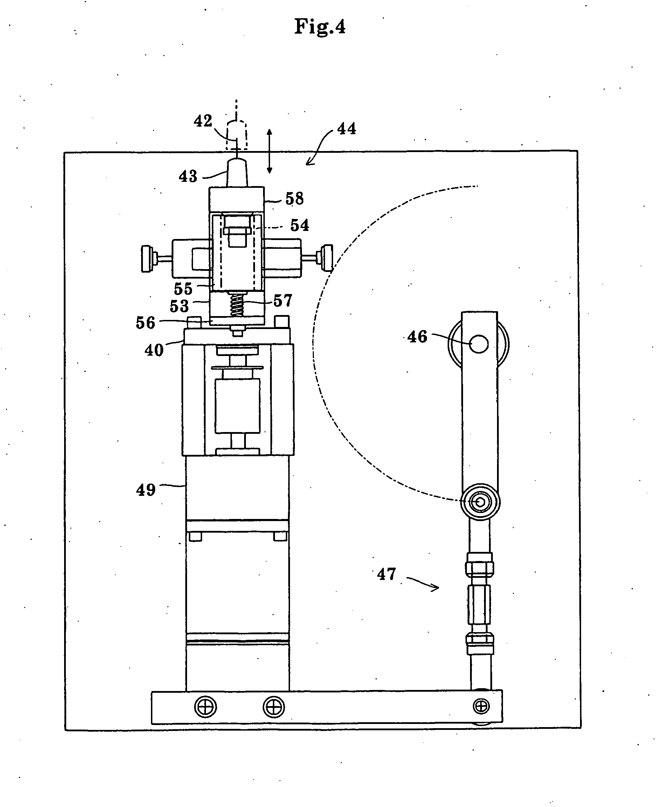

As illustrated in Figs. 2 and 4, the movable bench 40 is coupled to a rotational shaft 46 of a motor 45 and a link mechanism 47 having three joints. When the motor 45 is driven to rotate in a forward/backward direction, the movable bench 40 moves vertically along a vertical rail 48. Further, a motor 49 is provided at a free end of the movable bench 40. A rotational shaft 51 of the motor 49 is coupled to a support member 52 through a bearing 50. The support arms 41 are supported by the support member 52 at a side end such that a sliding motion in a horizontal direction can be adjusted. By such an adjustment of the support arm 41, it is possible to change a distance from the cutter blade 42 to the rotational axis center X of the motor 45. In other words, it is possible to change and adjust a turning radius of the cutter blade 42 in response to a diameter of a ring frame f to be used.

A support bracket 53 is secured to the free end of the support arm 41. A unit movable bench 55 allows the cutter unit 44 to slide along a vertical rail 54 of the support bracket 53. A horizontal bracket 56 is attached to an end of the support bracket 53. The unit movable bench 55 and the horizontal bracket 56 are coupled to each other through a spring 57 such that the unit movable bench 55 is elastically biased in a direction that the cutter blade 42 moves upward.

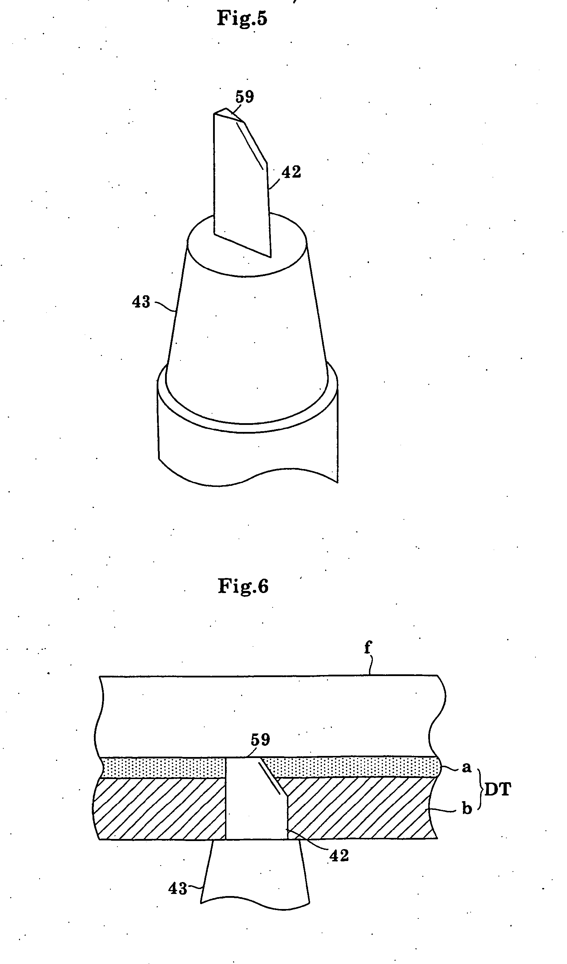

The cutter holder 43 is attached to a bracket 58 having a cylinder-shaped main body which is coupled to one end of the unit movable bench 55. The cutter blade 42 is attached to the tip end of the cutter holder 43. As illustrated in Fig. 5, the cutter blade 42 has a flat plane 59 obtained by forming a cutting edge thereof into a wedge shape.

The ring frame lift mechanism 26 is situated at a standby position located above a position where the adhesive tape DT is joined to a ring frame f. After completion of the operation of joining the adhesive tape DT to the ring frame f, the ring frame lift mechanism 26 moves downward, and then suction holds the ring frame f. Herein, the ring frame transport mechanism 17 holding the ring frame f before completion of the joining operation returns to an initial position located above the ring frame supply section 16.

Moreover, the ring frame lift mechanism 26 suction holding the ring frame f moves upward to a joining position where the ring frame f is joined to a wafer W. Herein, the chuck table 15 suction holding the wafer W moves downward to the joining position.

The mount frame preparation section 27 includes a joining roller 28 having a circumferential face which is elastically deformable. The joining roller 28 rolls on the non-adhesive surface of the adhesive tape DT while pressing the adhesive tape DT joined to a bottom side of the ring frame f against the wafer W.

The first mount frame transport mechanism 29 vacuum sucks a mount frame MF including the ring frame f and the wafer W integrated with each other, and then transfers the mount frame MF to a separation table (not illustrated) of the separation mechanism 30.

The separation mechanism 30 includes the separation table, a tape supply section 31, a separation unit 32 and a tape collection section 34. Herein, the separation table transports a wafer W placed thereon. The tape supply section 31 supplies a separating bonding tape (hereinafter, simply referred to as a "separating tape") Ts. The separation unit 32 performs a joining operation and a separating operation for the separating tape Ts. The tape collection section 34 collects the separating tape Ts together with a protective tape PT separated from the wafer W. Herein, the constituent elements of the separation mechanism 30 are fixedly provided in the semiconductor wafer mount apparatus 1, except the separation table.

The tape supply section 31 guides and supplies the separating tape Ts derived from an original tape roll to a lower end of the separation unit 32 through a guide roller.

The tape collection section 34 reels and collects the separating tape Ts fed from the lower end of the separation unit 32 so as to guide the separating tape Ts upward through a feed roller driven by a motor and a guide roller:

The separation unit 32 includes a separation plate 33. The separation plate 33 moves while pressing a surface of the protective tape PT joined to a patterned face of a wafer W (a wafer W joined to a ring frame f through the dicing tape DT in a mount frame MF) transported by the separation table. Herein, the separation plate 33 joins the separating tape Ts to the protective tape PT while pressing a non-adhesive surface of the separating tape Ts and, simultaneously, separates the protective tape PT together with the separating tape Ts. The separating tape Ts to be used herein has a width narrower than a diameter of the wafer W.

The second mount frame transport mechanism 35 vacuum sucks a mount frame MF supplied from the separation mechanism 30, and then transfers the mount frame MF to the turn table 36.

The turn table 36 performs alignment on the mount frame MF, and then the mount frame collection section 37 houses the mount frame MF. More specifically, a mount frame MF is placed on the turn table 36 by the second mount frame transport mechanism 35, and then is subjected to alignment on the basis of an orientation flat of a wafer W or a position of a ring frame f.

The turn table 36 is turned in order to change a direction that the mount frame collection section 37 houses a mount frame MF.

When the turn table 36 determines such a direction, a mount frame MF is pushed by a pusher (not illustrated), and then is housed in the mount frame collection section 37.

The mount frame collection section 37 is placed on a placement table (not illustrated) which is movable vertically. That is, when the placement table moves vertically, a mount frame MF pushed by the pusher can be housed in an any stage of the mount frame collection section 37.

With reference to Figs. 1 to 10, next, description will be given of a series of operations performed by the semiconductor wafer mount apparatus 1 according to this embodiment.

The wafer holding part of the arm 4 is inserted between wafers W housed in the cassette C, suction holds the wafer W from below, and takes the wafer W out of the cassette C. The arm 4 transports the wafer W to the alignment stage 7.

The wafer W is placed on the holding table by the arm 4, and then is suction held from below by the holding table. Herein, a pressure gauge (not illustrated) detects a suction level of the wafer W, and compares the detected level with a predetermined reference value in regard to a pressure value in a normal operation.

If the wafer W is suction held abnormally, the pressing plate 6 is pressed against a front face of the wafer W. Thus, the wafer W is suction held normally while being flattened (i.e., warpage of the wafer W is corrected). Herein, the wafer W is subjected to alignment on the basis of an orientation flat or a notch thereof.

After completion of the alignment by the alignment stage 7, the ultraviolet-ray irradiation unit 14 irradiates the front face of the wafer W with ultraviolet rays.

The alignment stage 7 moves toward the mount frame preparation section 27 in such a state that the wafer W irradiated with the ultraviolet rays is suction held by the holding table. That is, the alignment stage 7 moves to an intermediate position between the chuck table 15 and the ring frame lift mechanism 26.

When the alignment stage 7 is situated on standby at a predetermined position, the chuck table 15 situated above the alignment stage 7 moves downward. Thus, a bottom side of the chuck table 15 comes into contact with the wafer W, and the chuck table 15 starts to vacuum suck the wafer W. When the chuck table 15 starts to vacuum suck the wafer W, the holding table releases the suction of the wafer W. Thus, the wafer W is received by the chuck table 15 while being flattened (i.e., warpage of the wafer W is corrected). Thereafter, the alignment stage 7 returns to its initial position.

Next, one of ring frames f housed in the ring frame supply section 16 in a stacked manner is taken out of the ring frame supply section 16 while being vacuum sucked from above by the ring frame transport mechanism 17. The ring frame f is subjected to alignment at an alignment stage (not illustrated), and then is transported to an adhesive tape joining position located above an adhesive tape DT.

When the ring frame transport mechanism 17 transports the ring frame f to the adhesive tape joining position, the tape supply section 19 starts to supply the adhesive tape DT. Concurrently, the joining roller 22 moves to a joining operation start position.

When the joining roller 22 arrives at the joining operation start position, the tensioning mechanism 20 grasps both ends of the adhesive tape DT in a width direction and applies a tension to the adhesive tape DT in the width direction.

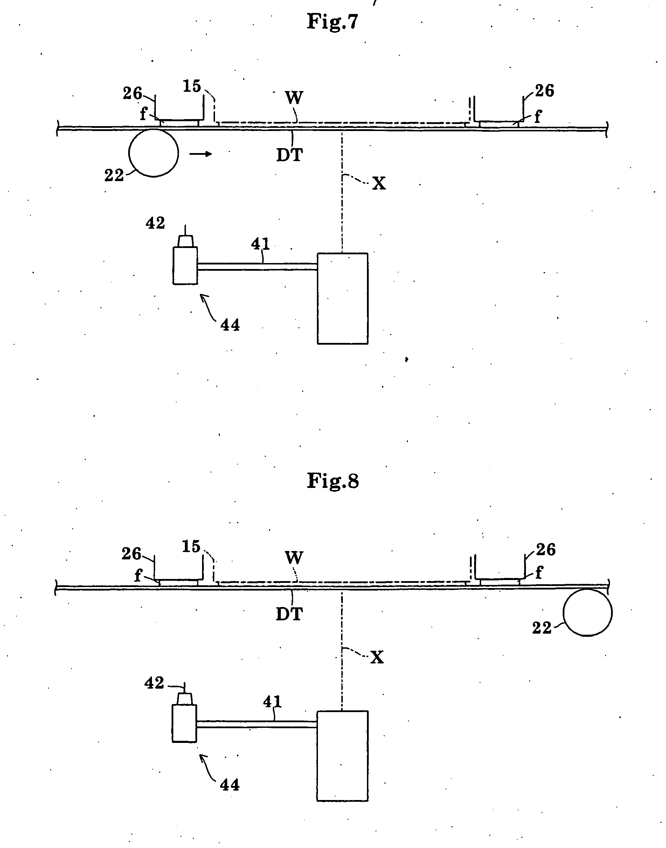

As illustrated in Figs. 7 and 8, then, the joining roller 22 moves upward in order to join the adhesive tape DT to an end of the ring frame f while pressing the adhesive tape DT against the end of the ring frame f. Then, the joining roller 22 rolls on a non-adhesive surface of the adhesive tape DT toward the tape supply section 19. That is, the joining roller 22 returns to its standby position. Thus, the adhesive tape DT is joined to the ring frame f. When the joining roller 22 arrives at its standby position, the tensioning mechanism 20 releases the grasp of the adhesive tape DT.

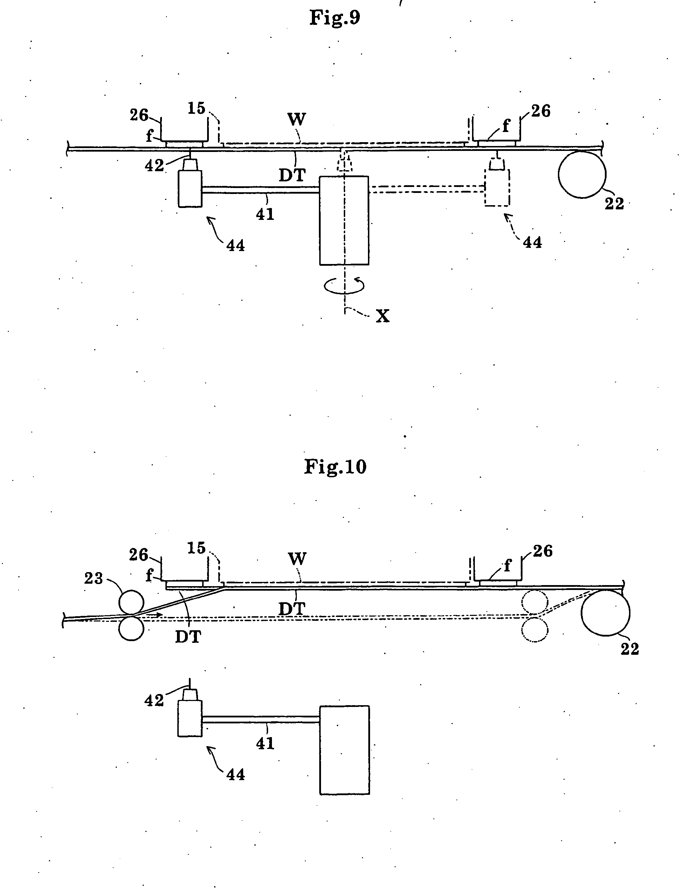

Concurrently, the tape cutting mechanism 24 moves upward, and the adhesive tape DT is stuck with the cutter blade 42 as illustrated in Fig. 9. As illustrated in Fig. 6, more specifically, the cutter blade 42 penetrates through a base a and an adhesive layer b of the adhesive tape DT, and the flat plane 59 formed at the cutting edge thereof is brought into contact with the tape joined side of the ring frame f. In this state, the motor 45 is driven to rotate such that the support arm 41 rotates about the vertical axis center X. Thus, the cutter blade 42 cuts the adhesive tape DT along the contour of the ring frame f. After completion of the cutting of the adhesive tape DT, as illustrated in Fig. 10, the removal unit 23 moves toward the tape supply section 19 and removes the unnecessary portion of the adhesive tape DT from the ring frame f.

Then, the tape supply section 19 is actuated to unreel the adhesive tape DT therefrom, and the unnecessary portion of the cut adhesive tape DT is fed to the tape collection section 25. Herein, the joining roller 22 moves to the joining operation start position in order to join the adhesive tape DT to a next ring frame f.

The ring frame f, to which the adhesive tape DT is joined, is moved upward in such a manner that the ring frame lift mechanism 26 moves upward while suction holding a frame side of the ring frame f. Herein, the chuck table 15 moves downward. That is, each of the chuck table 15 and the ring frame lift mechanism 26 moves to a position where the ring frame f and the wafer W are joined to each other.

At the predetermined position, each of the chuck table 15 and the ring frame lift mechanism 26 is held by a holding mechanism (not illustrated). Next, the joining roller 28 moves to an adhesive tape joining operation start position. Herein, the joining roller 28 rolls on a non-adhesive surface of the adhesive tape DT joined to the bottom side of the ring frame f to join the adhesive tape DT to the wafer W. Thus, the ring frame f is joined to the wafer W through the supporting adhesive tape DT to prepare a mount frame MF.

After the preparation of the mount frame MF, the chuck table 15 and the ring frame lift mechanism 26 move upward, respectively. Herein, a holding table (not illustrated) moves below the mount frame MF, so that the mount frame MF is placed on the holding table. Then, the first mount frame transport mechanism 29 suction holds the mount frame MF placed on the holding table, and transfers the mount frame MF to the separation table.

The separation table, on which the mount frame MF is placed, moves below the separation unit 32. Thereafter, the separation plate 33 joins a separating tape Ts supplied from the tape supply section 31 to the protective tape PT on the front face of the wafer W while pressing the separating tape Ts against the protective tape PT. Concurrently, the separation plate 33 separates the protective tape PT together with the separating tape Ts from the front face of the wafer W.

After completion of the separation of the protective tape PT, the separation table, on which the mount frame MF is placed, moves to the standby position of the second mount frame transport mechanism 35.

The second mount frame transport mechanism 35 receives the mount frame MF from the separation mechanism 30, and then transfers the mount frame MF to the turn table 36. The mount frame MF placed on the turn table 36 is subjected to alignment on the basis of an orientation flat or a notch and is subjected to adjustment for a housing direction. After the alignment and the adjustment, the mount frame MF is pushed by the pusher and is housed in the mount frame collection section 37.

As described above, in the case that the adhesive tape DT is stuck with the cutter blade 42 and the cutter blade 42 cuts the adhesive tape DT along the contour of the ring frame f while traveling along the contour of the contour of the ring frame f, even when the tape joined side of the ring frame f has a scratch, the cutting edge of the cutter blade 42 is not fitted into the scratch because of enlargement in area of the cutting edge by virtue of the flat plane 59. That is, it is possible to prevent a cutting pathway from changing due to an influence of the scratch on the tape joined side of the ring frame f. Thus, a cutting start position corresponds with a cutting end position, so that the supporting adhesive tape can be cut with certainty.

Moreover, the cutting edge of the cutter blade 42 is not fitted into the notched groove, and therefore does not receive unnecessary frictional resistance. As a result, the service life of the cutter blade 42 can be prolonged. Thus, a frequency of exchange of the cutter blade 42 can be reduced, so that workability can be improved.

Further, even when the cutter blade 42 cuts the adhesive tape DT in such a state that the cutting edge thereof comes into contact with the ring frame f, the flat plane 59 formed at the cutting edge of the cutter blade 42 prevents formation of a notched groove on the ring frame f. Accordingly, the ring frame f can be used repeatedly.

The present invention is not limited to the aforementioned embodiment, and may be modified variously as follows.
(1) In the foregoing embodiment, the side of the ring frame f, to which the adhesive tape DT is joined, is directed downward. Alternatively, such a side may be turned upside down upon performance of joining, cutting and separating of the adhesive tape DT.
(2) In the foregoing embodiment, the adhesive tape DT may be cut in a state that the flat plane 59 formed at the cutting edge of the cutter blade 42 does not completely penetrate through the adhesive tape DT. That is, the adhesive tape DT is cut at the moment that the flat plane 59 penetrates through the adhesive layer of the adhesive tape DT, in other words, at the position where the cutting edge is close to the ring frame f.

Further, the adhesive tape DT may be cut while a distance from the tape joined side of the ring frame f to the cutting edge of the cutter blade 42 is made constant.

In this case, a measurement device such as a light-reflection type sensor is disposed forward the cutter blade 42 in a cutter traveling direction to measure the aforementioned distance. The measurement device sends a result of the measurement to a control section (not illustrated). The control section obtains a deviation of the distance by comparison with a predetermined reference position. In accordance with this deviation, the control section allows a drive mechanism to move the cutter blade 42 in a vertical direction.
(3) In the foregoing embodiment, the adhesive tape DT is joined to a ring frame f and a back face of a wafer W concurrently. Alternatively, a joining roller may be used. That is, the dicing tape DT is joined to the ring frame f. Thereafter, the wafer W is made close to the center of the ring frame f, and the joining roller joins the dicing tape DT to the wafer W while pressing the dicing tape DT against the wafer W.

## Claims

1. A method for cutting a supporting adhesive tape (DT) through which a ring frame (f) holds a semiconductor wafer (W), the method comprising the step of:
cutting a supporting adhesive tape (DT) along a contour of a ring frame (f) in such a manner that the supporting adhesive tape (DT) is stuck with a cutter blade (42) having a wedge-shaped flat plane (59) which is facing a tape joined side of the ring frame (f) and arranged in parallel thereto.

2. The method of claim 1, wherein
the adhesive tape (DT) is cut while the flat plane (59) formed at the cutting edge of the cutter blade (42) with which the adhesive tape (DT) is stuck is brought into contact with a tape joined side of the ring frame (f).

3. The method of claim 1, wherein
the adhesive tape (DT) is cut in a state that the flat plane (59) formed at the cutting edge of the cutter blade (42) with which the adhesive tape (DT) is stuck is close to the tape joined side of the ring frame (f) while the flat plane (59) is left on an adhesive layer (a) of the adhesive tape (DT).

4. The method of claim 1, wherein
the adhesive tape (DT) is cut while a gap from the tape joined side of the ring frame (f) to the flat plane (59) of the cutter blade (42) is adjusted so as to be constant.

5. An apparatus (1) for joining a semiconductor wafer (W) to a ring frame (f) through a supporting adhesive tape (DT) such that the ring frame (f) holds the semiconductor wafer (W), the apparatus (1) comprising:
wafer holding means (15) for holding a semiconductor wafer (W);
frame holding means (26) for holding a ring frame (f) so as to be opposite to the semiconductor wafer (W) held by the wafer holding means (15);
tape supply means (19) for supplying a strip-shaped supporting adhesive tape (DT) toward the ring frame (f);
joining means (21) allowing a joining member (22) to move while being pressed against a non-adhesive surface of the adhesive tape (DT), for joining the semiconductor wafer (W) to the ring frame (f) such that the ring frame (f) holds the semiconductor wafer (W); and
removal means (23) for removing the unnecessary portion of the cut adhesive tape (DT) from the ring frame (f) **characterized in that**
a cutting mechanism (24) provided with a cutter blade (42) having a wedge-shaped flat plane (59) for cutting the adhesive tape (DT) along a contour of the ring frame (f) in such a manner that the adhesive tape (DT) is stuck with the cutter blade (42) and that the flat plane (59) is facing a tape joined side of the ring frame (f) and arranged in parallel thereto.

6. The apparatus of claim 5, further comprising:
measurement means for measuring a distance from a reference plane of a cutter holder (43) of the cutting mechanism (24) to the cutting edge of the cutter blade (42);
a control section for calculating a correction amount for correcting a length of the cutter blade (42) protruding from the cutter holder (43) in accordance with a deviation obtained by comparison of a value measured by the measurement means with a predetermined reference value; and
drive means for adjusting a protruding length of the cutter blade (42) in accordance with the correction amount obtained by the control section.

7. The apparatus of claim 6, wherein
the protruding length of the cutter blade (42) is adjusted to a length that the cutting edge of the cutter blade (42) is close to the surface of the ring frame (f).

## Patentansprüche

1. Verfahren zum Schneiden eines stützenden Klebebands (DT) durch das ein Ringrahmen (f) einen Halbleiter-Wafer (W) hält, wobei das Verfahren die folgenden Schritte umfasst:
Schneiden eines stützenden Klebebands (DT) entlang eines Umrisses eines Ringrahmens (f) auf solche Weise, dass das stützende Klebeband (DT) mit einem Messerkopf (42) abgestochen wird, der eine keilförmige flache Ebene (59) aufweist, die einer mit Band gefügten Seite des Ringrahmens (f) zugewandt und parallel dazu angeordnet ist.

2. Verfahren nach Anspruch 1, wobei
das Klebeband (DT) geschnitten wird, während die flache Ebene (59), die an der Schneide des Messerkopfs (42), mit der das Klebeband (DT) abgestochen wird, in Kontakt mit einer mit Band gefügten Seite des Ringrahmens (f) gebracht wird.

3. Verfahren nach Anspruch 1, wobei
das Klebeband (DT) in einem solchen Zustand geschnitten wird, dass die flache Ebene (59), die an der Schneide des Messerkopfs (42), mit dem das Klebeband (DT) abgestochen wird, gebildet ist, nahe der mit dem Band gefügten Seite des Ringrahmens (f) ist, während die flache Ebene (59) auf einer Klebeschicht (a) des Klebebands (DT) belassen wird.

4. Verfahren nach Anspruch 1, wobei
das Klebeband (DT) geschnitten wird, während ein Spalt von der mit Klebeband verbundenen Seite des Ringrahmens (f) zu der flachen Ebene (59) des Messerkopfs (42) so angepasst wird, dass er konstant ist.

5. Vorrichtung (1) zum Fügen eines Halbleiter-Wafers (W) an einen Ringrahmen (f) durch ein schützendes Klebeband (DT), so dass der Ringrahmen (f) den Halbleiter-Wafer (W) hält, wobei die Vorrichtung (1) umfasst:
ein Wafer-Haltemittel (15) zum Halten eines Halbleiter-Wafers (W);
ein Rahmenhaltemittel (26) zum Halten eines Ringrahmens (f), so dass er gegenüber dem Halbleiter-Wafer (W) liegt, der von dem Wafer-Haltemittel (15) gehalten wird;
ein Klebeband-Zuführmittel (19) zum Zuführen eines streifenförmigen stützenden Klebebands (DT) zu dem Ringrahmen (f);
ein Fügemittel (21), das einem Fügeelement (22) erlaubt, sich zu bewegen, während es gegen eine nicht klebende Fläche des Klebebands (DT) gepresst wird, zum Fügen des Halbleiter-Wafers (W) an den Ringrahmen (f), so dass der Ringrahmen (f) den Halbleiter-Wafer (W) hält; und
ein Entfernungsmittel (23) zum Entfernen des unnötigen Teils des geschnittenen Klebebands (DT) von dem Ringrahmen (f),
**dadurch gekennzeichnet, dass**
ein Schneidemechanismus (24), der mit einem Messerkopf (42) versehen ist, der eine keilförmige flache Ebene (59) zum Schneiden des Klebebands (DT) entlang eines Umrisses des Ringrahmens (f) in solcher Weise aufweist, dass das Klebeband (DT) mit dem Messerkopf (42) abgestochen wird, und dass die flache Ebene (59) einer mit Band gefügten Seite des Ringrahmens (f) zugewandt ist und parallel dazu angeordnet ist.

6. Vorrichtung nach Anspruch 5, überdies umfassend:
ein Messmittel zum Messen eines Abstands von einer Referenzebene einer Schneidgeräthalterung (43) des Schneidmechanismus' (24) zur Schneide des Messerkopfs (42);
einen Steuerabschnitt zum Berechnen eines Korrekturbetrags zum Korrigieren einer Länge des Messerkopfs (42), der von der Schneidgeräthalterung (43) hervorsteht, gemäß einer Abweichung, die durch den Vergleich eines Werts erhalten wird, der von dem Messmittel mit einem vorbestimmten Referenzwert gemessen wird; und
ein Antriebsmittel zum Anpassen einer hervorstehenden Länge des Messerkopfs (42) gemäß dem Korrekturbetrag, der von dem Steuerabschnitt erhalten wird.

7. Vorrichtung nach Anspruch 6, wobei
die hervorstehende Länge des Messerkopfs (42) auf eine solche Länge angepasst wird, dass die Schneide des Messerkopfs (42) nahe der Fläche des Ringrahmens (f) ist.

## Revendications

1. Procédé de découpe d'un ruban adhésif de support (DT) par lequel un cadre annulaire (f) maintient une tranche de semi-conducteur (W), le procédé comprenant l'étape consistant à :
découper un ruban adhésif de support (DT) le long d'un contour d'un cadre annulaire (f) d'une manière telle que le ruban adhésif de support (DT) soit transpercé avec une lame de couteau (42) ayant un plan plat en forme de coin (59) qui fait face à un côté relié par le ruban du cadre annulaire (f) et agencé en parallèle à celui-ci.

2. Procédé selon la revendication 1, dans lequel
le ruban adhésif (DT) est découpé tandis que le plan plat (59) formé au niveau du bord de découpe de la lame de couteau (42) avec laquelle le ruban adhésif (DT) est transpercé, est amené en contact avec un côté relié par le ruban du cadre annulaire (f).

3. Procédé selon la revendication 1, dans lequel
le ruban adhésif (DT) est découpé dans un état dans lequel le plan plat (59) formé au niveau du bord de découpe de la lame de couteau (42) avec laquelle le ruban adhésif (DT) est transpercé, est proche du côté relié par le ruban du cadre annulaire (f) tandis que le plan plat (59) est laissé sur une couche adhésive (a) du ruban adhésif (DT).

4. Procédé selon la revendication 1, dans lequel
le ruban adhésif (DT) est découpé tandis qu'un espace allant du côté relié par le ruban du cadre annulaire (f) au plan plat (59) de la lame de couteau (42) est réglé de manière à être constant.

5. Appareil (1) pour relier une tranche de semi-conducteur (W) à un cadre annulaire (f) par un ruban adhésif de support (DT) de sorte que le cadre annulaire (f) maintient la tranche de semi-conducteur (W), l'appareil (1) comprenant :
des moyens de maintien de tranche (15) pour maintenir une tranche de semi-conducteur (W) ;
des moyens de maintien de cadre (26) pour maintenir un cadre annulaire (f) de manière à être à l'opposé de la tranche de semi-conducteur (W) maintenue par les moyens de maintien de tranche (15) ;
des moyens de fourniture de ruban (19) pour fournir un ruban adhésif de support (DT) en forme de bande vers le cadre annulaire (f) ;
des moyens de liaison (21) permettant à un élément de liaison (22) de se déplacer tout en étant pressé contre une surface non adhésive du ruban adhésif (DT), pour relier la tranche de semi-conducteur (W) au cadre annulaire (f) de sorte que le cadre annulaire (f) maintient la tranche de semi-conducteur (W) ; et
des moyens de retrait (23) pour retirer la portion inutile du ruban adhésif découpé (DT) du cadre annulaire (f), **caractérisé en ce qu'**un mécanisme de découpe (24) est pourvu d'une lame de couteau (42) ayant un plan plat en forme de coin (59) pour découper le ruban adhésif (DT) le long d'un contour du cadre annulaire (f) d'une manière telle que le ruban adhésif (DT) soit transpercé avec la lame de couteau (42) et que le plan plat (59) fasse face à un côté relié par le ruban du cadre annulaire (f) et soit agencé en parallèle à celui-ci.

6. Appareil selon la revendication 5, comprenant en outre :
des moyens de mesure pour mesurer une distance depuis un plan de référence d'un support de couteau (43) du mécanisme de découpe (24) vers le bord de découpe de la lame de couteau (42) ;
une section de commande pour calculer une quantité de correction afin de corriger une longueur de la lame de couteau (42) faisant saillie depuis le support de couteau (43) conformément à un écart obtenu par comparaison d'une valeur mesurée par les moyens de mesure à une valeur de référence prédéterminée ; et
des moyens d'entraînement pour régler une longueur de saillie de la lame de couteau (42) conformément à la quantité de correction obtenue par la section de commande.

7. Appareil selon la revendication 6, dans lequel
la longueur de saillie de la lame de couteau (42) est réglée sur une longueur avec laquelle le bord de découpe de la lame de couteau (42) est proche de la surface du cadre annulaire (f).
